# EUROPEAN PATENT APPLICATION

(11) **EP 4 852 661 A1**
(43) Date of publication of application: **09.12.2026**
(21) Application number: 25186653.9
(22) Date of filing: 01.07.2025
(51) Int. Cl.: H10F 19/90, H10F 77/00

(54) **BUSBAR-FREE BACK-CONTACT PHOTOVOLTAIC MODULE AND METHOD FOR PREPARING THE SAME**

(30) Priority: 04.06.2025 CN 202510741794
(71) Applicant: Zhejiang Jinko Solar Co., Ltd., Haining, Zhejiang 314416 (CN)
(72) Inventor: WANG, Luchuang, YUAN HUA TOWN, HAINING, ZHEJIANG, 314416 (CN); PENG, Yingying, YUAN HUA TOWN, HAINING, ZHEJIANG, 314416 (CN); ZHANG, Ningbo, YUAN HUA TOWN, HAINING, ZHEJIANG, 314416 (CN); YANG, Xubing, YUAN HUA TOWN, HAINING, ZHEJIANG, 314416 (CN)
(74) Representative: Herrero & Asociados, S.L.

(57) **Abstract**

The present invention relates to a busbar-free back-contact photovoltaic module and a method for preparing the same. The method includes: arranging a plurality of cell sheets at intervals along a first direction; laying a plurality of first solder ribbons on at least a part of the cell sheets to form a cell string, wherein each of the plurality of first solder ribbons is connected to adjacent two cell sheets; connecting a first bus ribbon and a plurality of second solder ribbons to form a first assembly, and connecting a second bus ribbon and a plurality of third solder ribbons to form a second assembly; and; and laying the first assembly and the second assembly on the cell string, respectively.

## Description

### TECHNICAL FIELD

The present invention relates to the field of photovoltaic power generation technology, and in particular to a busbar-free back-contact photovoltaic module and a method for preparing the same.

### BACKGROUND

In a photovoltaic module, cell sheets are connected in series or in parallel through a specific connection method to form a path for current transmission. Adjacent cells are connected by solder ribbons, and a bus ribbon is used to collect the current transmitted by a plurality of solder ribbons, thereby collecting the current generated by the cell sheets to an output end of the photovoltaic module.

However, the arrangement of cell sheets and bus ribbons in conventional photovoltaic modules will form gaps in the photovoltaic modules, which not only reduces the working efficiency of the photovoltaic modules, reduces the utilization rate of light, but also causes problems such as light leakage.

### SUMMARY

Accordingly, it is necessary to provide a busbar-free back-contact photovoltaic module and a method for preparing the same to address the problems of low working efficiency and light utilization rate of photovoltaic modules.

A method for preparing a busbar-free back-contact photovoltaic module is provided, including:
arranging a plurality of cell sheets at intervals along a first direction;
laying a plurality of first solder ribbons on at least a part of the plurality of cell sheets to form a cell string, wherein each of the plurality of first solder ribbons is connected to adjacent two cell sheets;
connecting a first bus ribbon and a plurality of second solder ribbons to form a first assembly, and connecting a second bus ribbon and a plurality of third solder ribbons to form a second assembly; and
laying the first assembly and the second assembly on the cell string, respectively;
wherein laying the first assembly and the second assembly on the cell string, respectively includes:
   laying the first bus ribbon on outer edges of the cell sheets located at two ends of the cell string along the first direction, respectively, and laying the plurality of second solder ribbons on the cell sheets located at two ends of the cell string along the first direction; and
   laying the second bus ribbon between adjacent two cell sheets, and laying the plurality of third solder ribbons on two cell sheets located on both sides of the second bus ribbon along the first direction.

In one embodiment, the plurality of second solder ribbons and the plurality of first solder ribbons are arranged alternately in a second direction perpendicular to the first direction; and/or
the plurality of third solder ribbons and the plurality of first solder ribbons are arranged alternately in a second direction perpendicular to the first direction.

In one embodiment, after laying the plurality of first solder ribbons on at least a part of the plurality of cell sheets to form the cell string, the method further includes:
applying a glue on the plurality of cell sheets and the plurality of first solder ribbons to form a plurality of glue spots, wherein the plurality of cell sheets and the plurality of first solder ribbons are connected through the plurality of glue spots.

In one embodiment, two ends of at least a part of the plurality of first solder ribbons are connected to the plurality of cell sheets through at least two glue spots spaced apart in a length direction thereof.

In one embodiment, the method further includes:
applying a glue on the plurality of cell sheets and the plurality of second solder ribbons to form a plurality of glue spots, wherein the plurality of cell sheets and the plurality of second solder ribbons are connected through the plurality of glue spots;
applying a glue on the plurality of cell sheets and the plurality of third solder ribbon to form a plurality of glue spots, wherein the plurality of cell sheets and the plurality of third solder ribbons are connected through the plurality of glue spots.

In one embodiment, at least a part of the plurality of second solder ribbons is provided with at least two glue spots, and all the glue spots on a same second solder ribbon are respectively provided at opposite ends of the second solder ribbon in a length direction thereof; and/or
at least a part of the plurality of third solder ribbons is provided with at least two glue spots, and all the glue spots on a same third solder ribbon are respectively provided at opposite ends of the third solder ribbon in a length direction thereof.

In one embodiment, the method further includes:
arranging a plurality of cell strings at intervals along a second direction perpendicular to the first direction; and
soldering the plurality of first bus ribbons or the plurality of second bus ribbons of adjacent two cell strings.

A busbar-free back-contact photovoltaic module prepared by the above-mentioned method is provided.

In one embodiment, the busbar-free back-contact photovoltaic module includes a plurality of cell strings arranged at intervals, and each of the plurality of cell strings includes:
a plurality of cell sheets arranged at intervals along a first direction;
a plurality of first solder ribbons laid on at least a part of the plurality of cell sheets, and each of the plurality of first solder ribbons is connected to adjacent two cell sheets;
a first bus ribbon provided at outer edges of the cell sheets located at two ends of the cell string along the first direction;
a plurality of second solder ribbons that are connected to the first bus ribbon and provided on the cell sheets located at two ends of the cell string along the first direction;
a second bus ribbon provided between adjacent two cell sheets; and
a plurality of third solder ribbons that are connected to the second bus ribbon and provided on two cell sheets located on both sides of the second bus ribbon along the first direction.

In one embodiment, in any cell string located between two cell strings, one first bus ribbon is connected to another first bus ribbon of another cell string located on one side thereof, and one second bus ribbon is connected to another second bus ribbon of another cell string located on another side thereof.

The above-mentioned method for preparing a busbar-free back-contact photovoltaic module is applied to the production of busbar-free back-contact photovoltaic modules. Since the first bus ribbon and the second bus ribbon are both arranged on the backlight side of the cell sheet, there is no need to arrange a bus ribbon between the cell sheet and the edge of the cover plate, thereby effectively reducing the gap of the busbar-free back-contact photovoltaic module, which can in turn effectively increase the overall size of the busbar-free back-contact photovoltaic module and improve the power of the busbar-free back-contact photovoltaic module. In addition, since the first bus ribbon and the second solder ribbon are independently formed into a first assembly, and the second bus ribbon and the third solder ribbon are independently formed into a second assembly, the preparation process of the busbar-free back-contact photovoltaic module is simplified, and the problem of grid line breakage caused by secondary soldering is effectively prevented.

### BRIEF DESCRIPTION OF THE DRAWINGS

The accompanying drawings constituting a part of the present invention are used to provide a further understanding of the present invention. The illustrative embodiments of the present invention and their descriptions are used to explain the present invention and do not constitute improper limitations on the present invention.

To illustrate the technical solutions according to the embodiments of the present invention more clearly, the accompanying drawings for describing the embodiments are introduced briefly in the following. Apparently, the accompanying drawings in the following description are only some embodiments of the present invention, and persons of ordinary skill in the art can derive other drawings from the accompanying drawings without creative efforts.
FIG. 1 is a schematic view of a busbar-free back-contact photovoltaic module according to an embodiment of the present invention.
FIG. 2 is a flow chart of a method for preparing a busbar-free back-contact photovoltaic module according to an embodiment of the present invention.
FIG. 3 is a schematic view of step S1 of a method for preparing a busbar-free back-contact photovoltaic module according to an embodiment of the present invention.
FIG. 4 is a schematic view of step S2 of a method for preparing a busbar-free back-contact photovoltaic module according to an embodiment of the present invention.
FIG. 5 is a schematic view of step S3 of a method for preparing a busbar-free back-contact photovoltaic module according to an embodiment of the present invention.
FIG. 6 is a partial schematic view of step S4 of a method for preparing a busbar-free back-contact photovoltaic module according to an embodiment of the present invention.
FIG. 7 is a partial schematic view of step S4 of a method for preparing a busbar-free back-contact photovoltaic module according to an embodiment of the present invention.
FIG. 8 is a schematic view of step S5 of a method for preparing a busbar-free back-contact photovoltaic module according to an embodiment of the present invention.
FIG. 9 is a schematic view of steps S6 and S7 of a method for preparing a busbar-free back-contact photovoltaic module according to an embodiment of the present invention.
FIG. 10 is a schematic view of steps S8 and S of a method for preparing a busbar-free back-contact photovoltaic module according to an embodiment of the present invention.

### DETAILED DESCRIPTION OF THE EMBODIMENTS

In order to make the above objectives, features and advantages of the present invention more obvious and understandable, specific embodiments of the present invention are described in detail below with reference to the accompanying drawings. In the following description, many specific details are set forth in order to fully understand the present invention. However, the present invention can be implemented in many other ways different from those described herein, and those skilled in the art can make similar improvements without departing from the connotation of the present invention. Therefore, the present invention is not limited by the specific embodiments disclosed below.

In the description of the present invention, it should be understood that terms "center", "longitudinal", "transverse", "length", "width", "thickness", "upper", "lower", "front", "rear", "left", "right", "vertical", "horizontal", "top", "bottom", "inside", "outside", "clockwise", "counterclockwise", "axial", "radial", "circumferential", etc. indicate an orientation or a positional relationship based on an orientation or a positional relationship shown in the drawings, which is only for the purpose of facilitating and simplifying the description of the present invention, rather than indicates or implies that the device or elements must have a specific orientation, be constructed and operated in a specific orientation, and therefore cannot be construed as limitation of the present invention.

In addition, the terms "first" and "second" are used for descriptive purposes only, which cannot be construed as indicating or implying a relative importance, or implicitly specifying the number of the indicated technical features. Therefore, the features defined with "first" and "second" may explicitly or implicitly include at least one of the features. In the description of the present invention, "plurality" means at least two, such as two, three, etc., unless otherwise specifically defined.

In the present invention, unless otherwise explicitly specified and defined, the terms "mounted", "coupled", "connected", and "fixed" should be understood in a broad sense. For example, it may be a fixed connection, or a detachable connection, or integrated; it may be a mechanical connection, or an electrical connection; it may be a direct connection, an indirect connection through an intermediate medium, it may be an internal connection between two elements, or an interaction between two elements. For a person skilled in the art, the specific meaning of the aforementioned terms in the present invention can be understood according to specific situations.

In the present invention, unless otherwise explicitly specified and defined, a first feature being "on" or "under" a second feature may mean that the first feature is in direct contact with the second feature, or the first feature is in indirect contact with the second feature via an intermediate medium. Furthermore, the first feature being "above", "over", or "on" the second feature may refer to that the first feature is directly above or obliquely above the second feature, or refer to that the height of the first feature is greater than the height of the second feature. The first feature being "below", "underneath" or "under" the second feature may refer to that the first feature is directly below or obliquely below the second feature, or refer to that the height of the first feature is less than the second feature.

It should be noted that, if an element is referred to as being "fixed to" or "disposed on" another element, the element may be directly on another element or there may be an intermediate element therebetween. If an element is referred to as "connected to" another element, the element may be directly connected to another element or there may be an intermediate element therebetween. If present, the terms "vertical", "horizontal", "upper", "lower", "left", "right", and similar expressions used herein are for illustrative purposes only and are not meant to be the only means of implementation.

A back-contact photovoltaic module is a photovoltaic module in which the emitter and base electrodes are arranged on the back side (non-light-receiving side). Since there is no metal electrode blocking the front side (light-receiving side) of the back-contact photovoltaic module, the short-circuit current of the photovoltaic module is effectively increased, thereby increasing the energy conversion efficiency of the photovoltaic module.

Further, in the back-contact photovoltaic module, a solder ribbon is used to replace the busbar and directly connected to the finger to form a busbar-free back-contact photovoltaic module, which not only can improve the conductive performance, but can also reduce the amount of paste used, and greatly reduce the production cost of photovoltaic modules. In addition, the shading area of grid lines in the busbar-free back-contact photovoltaic module can be effectively reduced, thereby reducing transmission loss, and increasing the total power of photovoltaic modules. Furthermore, the increase in finger contact points can also reduce the risk of hidden cracks and improve the yield and reliability of photovoltaic modules.

However, as described in the background, there are gaps between adjacent cell sheets, between bus ribbons and cell sheets, and between bus ribbons and edges of the photovoltaic module in conventional busbar-free back-contact photovoltaic modules. The existence of these gaps reduces the effective area of busbar-free back-contact photovoltaic modules, which not only reduces the working efficiency and light utilization rate of busbar-free back-contact photovoltaic modules, but also causes problems such as light leakage in busbar-free back-contact photovoltaic modules.

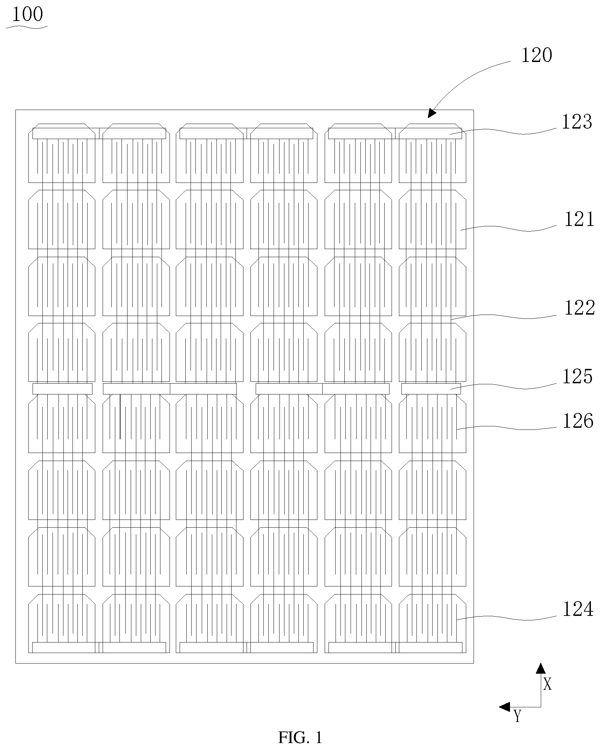

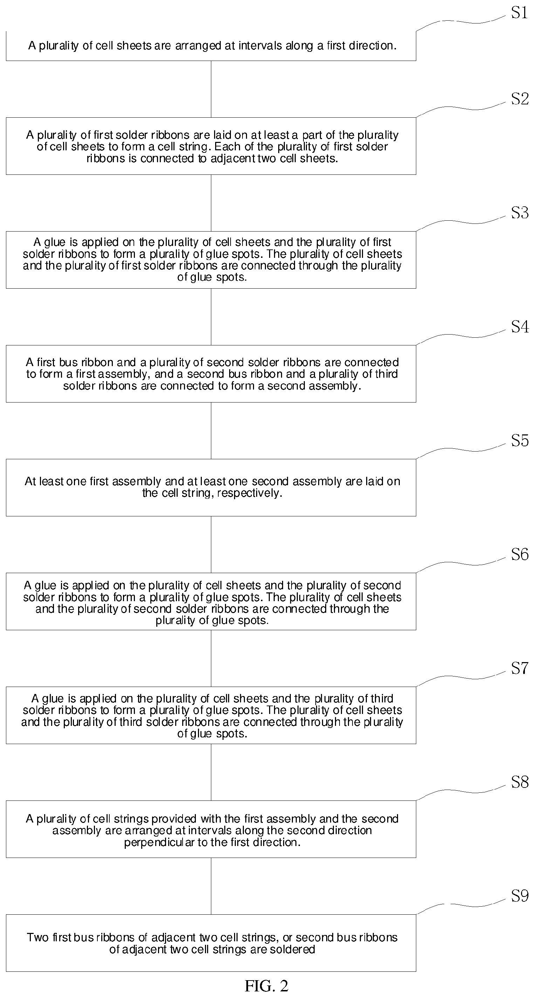

In view of the aforementioned technical problems, as shown in FIGS. 1 and 2, a method for preparing a busbar-free back-contact photovoltaic module 100 is provided according to an embodiment of the present invention. The method includes the following steps.

Step S1, a plurality of cell sheets are arranged at intervals along a first direction.

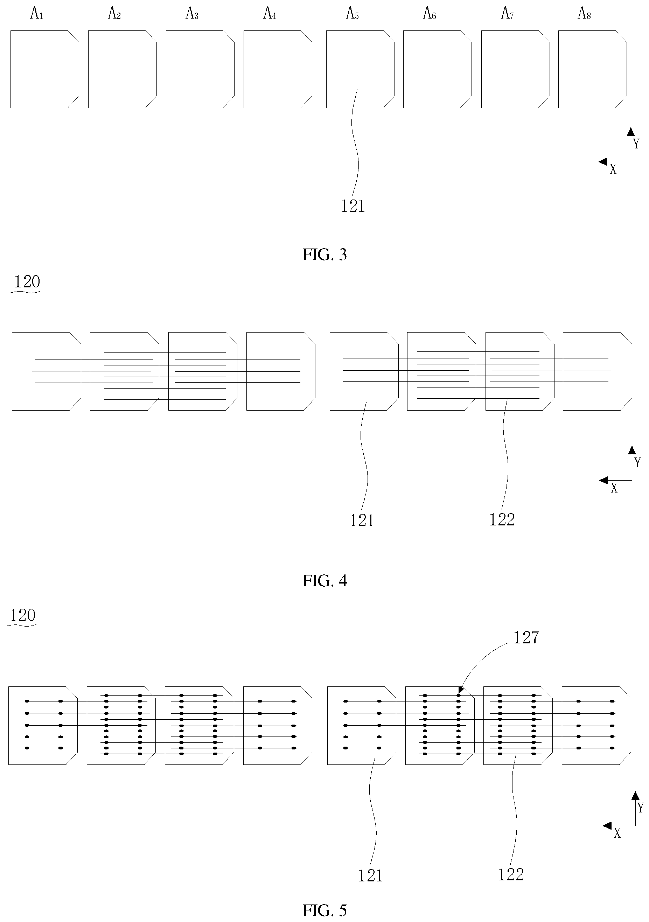

As shown in FIG. 3, the cell sheet 121 is specifically a multi-split cell sheet, and the cell sheet 121 is generally a rectangular sheet. In the following embodiments, a width direction of the cell sheet 121 is defined as a first direction (i.e., the X direction in FIG. 1), a length direction of the cell sheet 121 is defined as a second direction (i.e., the Y direction in FIG. 1), and a thickness direction of the cell sheet 121 is defined as a third direction. The first direction, the second direction, and the third direction are perpendicular to one another.

The cell sheet 121 includes a light-receiving side and a backlight side that are arranged opposite to each other in the third direction. The light-receiving side of the cell sheet 121 is configured to receive sunlight to obtain solar energy. In one embodiment, backlight sides of the plurality of cell sheets 121 are placed upwards to facilitate subsequent operations.

Specifically, in one embodiment, as shown in FIG. 3, cell sheets A₁, A₂...Aₙ...A₂ₙ with a number of 2n are arranged at intervals in a row along the first direction. Cell sheets A₁ and A₂ₙ are located at two ends of the row along the first direction, respectively, and cell sheets Aₙ and Aₙ₊₁ are located in a middle of the row. Specifically, in FIG. 3, in one embodiment, n=4, which means 8 cell sheets 121 are provided. Cell sheets A₁, A₂...A₄...A₈ are arranged sequentially in a row, cell sheets A₁ and A₈ are located at two ends of the row, and cell sheets A₄ and A₅ are located in the middle of the row. It should be understood that the shape, area, number of the cell sheets 121 and the interval between adjacent two cell sheets 121 are not limited and can be provided as required to meet different requirements.

Step S2, a plurality of first solder ribbons are laid on at least a part of the plurality of cell sheets to form a cell string. Each of the plurality of first solder ribbons is connected to adjacent two cell sheets.

As shown in FIG. 4, the first solder ribbon 122 is a ribbon with flexibility, and the first solder ribbon 122 is made of a material including but not limited to tin-lead alloy and lead-free alloy (such as tin-silver-copper alloy). The plurality of first solder ribbons 122 are laid on the cell sheets 121 to connect the cell sheets 121. The cell sheets 121 are well electrically connected via the first solder ribbons 122, which then collects and conducts the current generated by each cell sheet 121.

In one embodiment, except for the two cell sheets 121 located in the middle of the cell string 120 in the first direction that are not connected to each other through the first solder ribbon 122, the remaining adjacent two cell sheets 121 are connected through the plurality of first solder ribbons 122. Each first solder ribbon 122 extends along the first direction, and both ends of each first solder ribbon 122 in the first direction are respectively laid on the backlight sides of adjacent two cell sheets 121 to connect the adjacent two cell sheets 121. All the first solder ribbons 122 connecting the same two cell sheets 121 are arranged at intervals in the second direction perpendicular to the first direction. It can be understood that the length, width, number of the first solder ribbons 122 and the interval between adjacent two first solder ribbons 122 in the second direction can be provided as required.

Specifically, in one embodiment, as shown in FIG. 4, except that the adjacent cell sheets Aₙ and Aₙ₊₁ located in the middle of the cell string 120 are not connected to each other through the first solder ribbon 122, the remaining cell sheets A₁ and A₂, cell sheets A₂ and A₃......cell sheets A₂ₙ₋₁ and A₂ₙ are connected to each other through the plurality of first solder ribbons 122. All the first solder ribbons 122 connecting the same two cell sheets 121 (for example, all the first solder ribbons 122 connecting cell sheets A₁ and A₂) are arranged at intervals along the second direction.

Further, except for the cell sheets A₁ and A₂ₙ located at two ends of the cell string 120 along the first direction, and except that each first solder ribbon 122 on the cell sheets Aₙ and Aₙ₊₁ located in the middle of the cell string 120 is only connected to another cell sheet 121 on one side of the cell sheet 121, the remaining cell sheets 121 are all located between the two cell sheets 121, therefore the first solder ribbons 122 on the cell sheets 121 located between two cell sheets 121 are alternately connected to the cell sheets 121 on both sides. For example, among all the first solder ribbons 122 on the cell sheet A₃, along the second direction from one end to the other end of the cell sheet 121, the first solder ribbon 122 is connected to the cell sheet A₂, the second first solder ribbon 122 is connected to the cell sheet A₄, and the third first solder ribbon 122 is connected to the cell sheet A₂.

Step S3, a glue is applied on the plurality of cell sheets and the plurality of first solder ribbons to form a plurality of glue spots. The plurality of cell sheets and the plurality of first solder ribbons are connected through the plurality of glue spots.

Referring to FIG. 5, in one embodiment, the glue spots 127 are formed of a material with adhesive ability. The material of the glue spots 127 includes but is not limited to at least one of acrylic acid, epoxy resin, and conductive glue. The shape of the positive projection of the glue spots 127 on the cell sheets 121 includes but is not limited to at least one of a circle, an oval, and a rectangle, which can be provided as required to meet different fixing requirements.

By applying the glue on the cell sheets 121 and the first solder ribbons 122 to form the glue spots 127, not only can a more accurate positioning of the first solder ribbons 122 be provided, but also the first solder ribbons 122 and the cell sheets 121 can be preliminarily fixed, which helps to increase the tension between the first solder ribbons 122 and the cell sheets 121 and enhance the structural stability between the first solder ribbons 122 and cell sheets 121.

In some embodiment, two ends of at least a part of the first solder ribbons 122 are connected to the cell sheets 121 through at least two glue spots 127 that are spaced apart in a length direction thereof. Specifically, in one embodiment, two ends of all the first solder ribbons 122 are connected to one cell sheet 121 through at least two glue spots 127, and the plurality of glue spots 127 are adjacent to two edges of the cell sheet 121 in the first direction. That is, a part of the glue spots 127 is adjacent to one edge of the cell sheet 121 in the first direction, and the other part of the glue spots 127 is adjacent to another edge of the cell sheet 121 in the first direction. It should be understood that the number and location of the glue spots 127 are not limited hereto and can be provided as required to meet different fixing requirements.

Since the glue spots 127 on two ends of the first solder ribbons 122 in the length direction thereof are adjacent to two edges of the cell sheets 121 in the first direction, respectively, it can not only more effectively limit the movement of the first solder ribbons 122 in the length direction thereof, but can also reduce the risk of deformation of the first solder ribbons 122 due to factors such as thermal stress. When the busbar-free back-contact photovoltaic module 100 is subjected to a tensile force in the first direction, for example, it may be stretched by the installation structure during the installation of the busbar-free back-contact photovoltaic module 100, or a tensile force in the first direction may be generated due to improper fixation during transportation, the glue spots 127 adjacent to two edges of the cell sheets 121 in the first direction can more effectively resist this tensile force.

Furthermore, the glue spots 127 adjacent to two edges of the cell sheets 121 in the first direction can also change the stress distribution of the first solder ribbons 122 when a force is applied in the first direction. In a case when no glue spots 127 for fixing are provided, the tensile force will be concentrated on connections between the first solder ribbons 122 and the cell sheets 121, which is prone to cause loose connections or breakage of the cell sheets 121. With the glue spots 127, the tensile force will be dispersed to binding interfaces between the glue spots 127 and the cell sheets 121, and between the glue spots 127 and the first solder ribbons 122. This stress dispersion mechanism reduces the stress at each location, lowering the risk of damage due to stress concentration.

Moreover, in the second direction, when the busbar-free back-contact photovoltaic module 100 is subjected to a shear force, such as a lateral wind pressure generated on the surface of the busbar-free back-contact photovoltaic module 100 when subjected to strong winds, or a lateral friction force encountered during transportation, the glue spots 127 can play an anti-shearing role.

Step S4, a first bus ribbon and a plurality of second solder ribbons are connected to form a first assembly, and a second bus ribbon and a plurality of third solder ribbons are connected to form a second assembly.

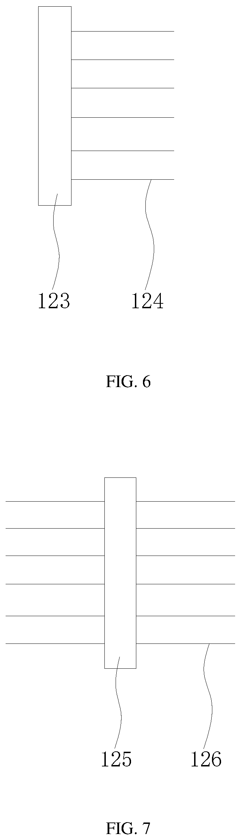

Referring to FIG. 6, in one embodiment, the step of forming the first assembly includes: a plurality of second solder ribbons 124 are firstly arranged at intervals along a straight line direction, and the interval between adjacent two second solder ribbons 124 can be set as required. Then, a first bus ribbon 123 is placed at ends of all the second solder ribbons 124 in a length direction thereof. A length direction of the first bus ribbon 123 is parallel to a direction along which the second solder ribbons 124 are arranged at intervals. Finally, the first bus ribbon 123 and all the second solder ribbons 124 are soldered to form the first assembly. That is, in the first assembly, one end of the second solder ribbon 124 is connected to the first bus ribbon 123, and the other end thereof extends along a width direction of the first bus ribbon 123 towards one side of the first bus ribbon 123.

The second solder ribbons 124 are ribbons made of a metal material such as a tin-lead alloy, a lead-free alloy (such as a tin-silver-copper alloy), and the first bus ribbon 123 is in an elongated ribbon formed of a conductive metal strip.

In this way, the plurality of second solder ribbons 124 and the first bus ribbon 123 are connected independently to form the first assembly, thereby simplifying the preparation process of the busbar-free back-contact photovoltaic module 100 and reducing the difficulty of connecting the first bus ribbon 123.

Referring to FIG. 7, in one embodiment, the step of forming the second assembly includes: a plurality of third solder ribbons 126 are first arranged at intervals along a straight line direction, and the interval between adjacent two third solder ribbons 126 can be set as required. Then, a second bus ribbon 125 is placed at a middle portion of the plurality of third solder ribbons 126 in a length direction thereof, and a length direction of the second bus ribbon 125 is parallel to a direction along which the third solder ribbons 126 are arranged at intervals. Finally, the second bus ribbon 125 and all the third solder ribbons 126 are soldered to form the second assembly. That is, in the second assembly, the middle portion of the plurality of third solder ribbons 126 is connected to the second bus ribbon 125, and two ends of the third solder ribbons 126 extend along a width direction of the second bus ribbon 123 towards two side of the second bus ribbon 123, respectively.

The third solder ribbon 126 is a ribbon made of a metal material such as a tin-lead alloy, a lead-free alloy (such as a tin-silver-copper alloy), and the second bus ribbon 125 is an elongated ribbon formed of a conductive metal strip.

In this way, the plurality of third solder ribbons 126 and the second bus ribbon 125 are connected independently to form the second assembly, thereby simplifying the preparation process of the busbar-free back-contact photovoltaic module 100 and reducing the difficulty of connecting the second bus ribbon 125.

Step S5, at least one first assembly and at least one second assembly are laid on the cell string, respectively.

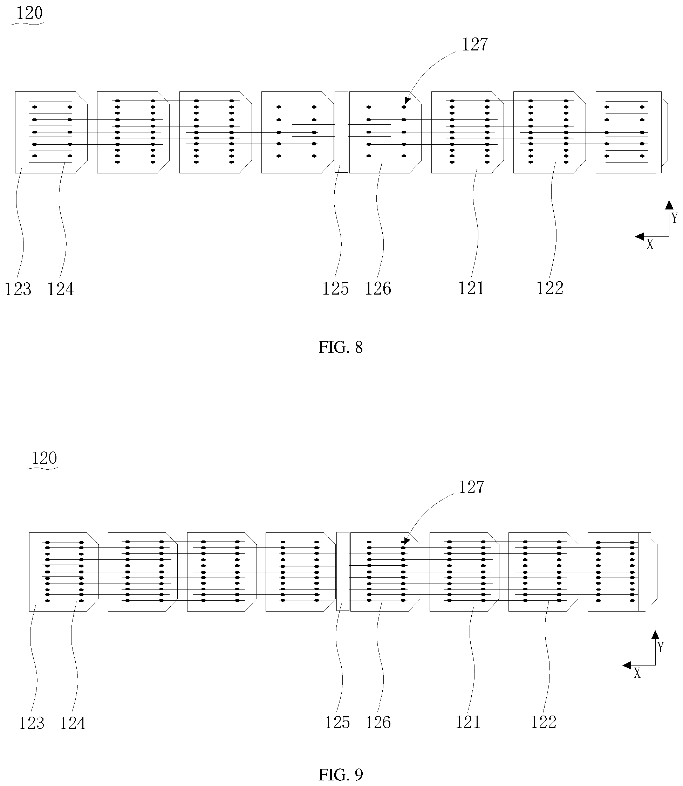

Referring to FIG. 8, in some embodiments, step S5 specifically includes the following steps.

Step S51, the first bus ribbon is laid on outer edges of the cell sheets located at two ends of the cell string along the first direction, and the plurality of second solder ribbons are laid on the cell sheets located at two ends of the cell string along the first direction, respectively.

Specifically, in one embodiment, two first assemblies are laid on the cell sheets A₁ and A₂ₙ located at two ends of the cell string 120 in the first direction, respectively.

In one embodiment, the first bus ribbon 123 of one of the first assemblies is laid on the outer edge of the cell sheet A₁ away from the cell sheet A₂ and extends along the second direction, and the second solder ribbons 124 are arranged at intervals on the cell sheet A₁ along the second direction. Each second solder ribbon 124 extends along the first direction, and the first solder ribbons 122 and the second solder ribbons 124 on the cell sheet A₁ are arranged alternately sequentially in the second direction.

The first bus ribbon 123 of another first assembly is laid on the outer edge of the cell sheet A₂ₙ away from the cell sheet A₂ₙ₋₁ and extends along the second direction, and the second solder ribbons 124 are arranged at intervals on the cell sheet A₂ₙ along the second direction. Each second solder ribbon 124 extends along the first direction, and the first solder ribbons 122 and the second solder ribbons 124 on the cell sheet A₂ₙ are arranged alternately sequentially in the second direction.

Step S52, the second bus ribbon is laid between adjacent two cell sheets, and the plurality of third solder ribbons are laid on two cell sheets located on both sides of the second bus ribbon along the first direction.

Specifically, in one embodiment, one assembly is laid in the middle portion of the cell string 120 in the first direction.

In one embodiment, the second bus ribbon 125 is located in a gap between adjacent cell sheets Aₙ and Aₙ₊₁ and extends along the second direction. Two ends of the third solder ribbons 126 are respectively laid on the adjacent cell sheets Aₙ and Aₙ₊₁. Each third solder ribbon 126 extends along the first direction, and the third solder ribbons 126 and the first solder ribbons 122 on the cell sheets Aₙ and Aₙ₊₁ are arranged alternately sequentially in the second direction.

In this way, through step S5, the first bus ribbon 123 and the second bus ribbon 125 are arranged in the cell string 120, and are electrically connected to the cell sheets 121 through the second solder ribbons 124 and the third solder ribbons 126, respectively. The first bus ribbon 123 and the second bus ribbon 125 are configured to electrically connect a plurality of cell strings 120, which can effectively transmit current, ensure the smooth flow of current between the cell strings 120, and reduce current loss.

Step S6, a glue is applied on the plurality of cell sheets and the plurality of second solder ribbons to form a plurality of glue spots. The plurality of cell sheets and the plurality of second solder ribbons are connected through the plurality of glue spots.

Referring to FIG. 9, in one embodiment, the glue spots 127 are components formed of a material with adhesive ability. The glue spot 127 is made of a material including but not limited to at least one of acrylic acid, epoxy resin, and conductive glue. The shape of the positive projection of the glue spot 127 on cell sheets 121 includes but is not limited to at least one of a circle, an oval, and a rectangle.

By applying the glue on the cell sheets 121 and the second solder ribbons 124 to form the glue spots 127, not only can a more accurate positioning of the second solder ribbons 124 be provided, but the second solder ribbons 124 and the cell sheets 121 can also be preliminarily fixed, which helps to increase the tension between the second solder ribbons 124 and the cell sheets 121 and enhance the structural stability between the second solder ribbons 124 and cell sheets 121.

In some embodiments, each second solder ribbon 124 is provided with at least two glue spots 127, and all glue spots 127 on the same second solder ribbon 124 are arranged at opposite ends of the second solder ribbon 124 in the length direction of the second solder ribbon 124. In this way, not only can the movement of the second solder ribbons 124 in the length direction thereof be more effectively limited, but also the stress distribution of the second solder ribbons 124 when subjected to a force can be changed, thereby playing an anti-shearing role.

Step S7, a glue is applied on the plurality of cell sheets and the plurality of third solder ribbons to form a plurality of glue spots. The plurality of cell sheets and the plurality of third solder ribbons are connected through the plurality of glue spots.

In one embodiment, the glue spots 127 are components formed of a material with adhesive ability. The glue spot 127 is made of a material including but not limited to at least one of acrylic acid, epoxy resin, and conductive glue. The shape of the positive projection of the glue spot 127 on cell sheets 121 includes but is not limited to at least one of a circle, an oval, and a rectangle.

By applying the glue on the cell sheets 121 and the third solder ribbons 126 to form the glue spots 127, not only can a more accurate positioning of the third solder ribbons 126 be provided, but the third solder ribbons 126 and the cell sheets 121 can also be preliminarily fixed, which helps to increase the tension between the third solder ribbons 126 and the cell sheets 121 and enhance the structural stability between the third solder ribbons 126 and cell sheets 121.

Specifically, in one embodiment, at least two glue spots 127 are respectively provided at two ends of each third solder ribbon 126 in the length direction, such that each third solder ribbon 126 is connected to the cell sheet 121 through the at least two glue spots 127, and the two glue spots 127 located on a same cell sheet 121 are adjacent to two edges of the cell sheet 121 in the first direction, respectively. In this way, not only can the movement of the third solder ribbons 126 in the length direction thereof be more effectively limited, but also the stress distribution of the third solder ribbons 126 when subjected to a force can be changed, thereby playing an anti-shearing role.

Step S8, a plurality of cell strings provided with the first assembly and the second assembly are arranged at intervals along the second direction perpendicular to the first direction.

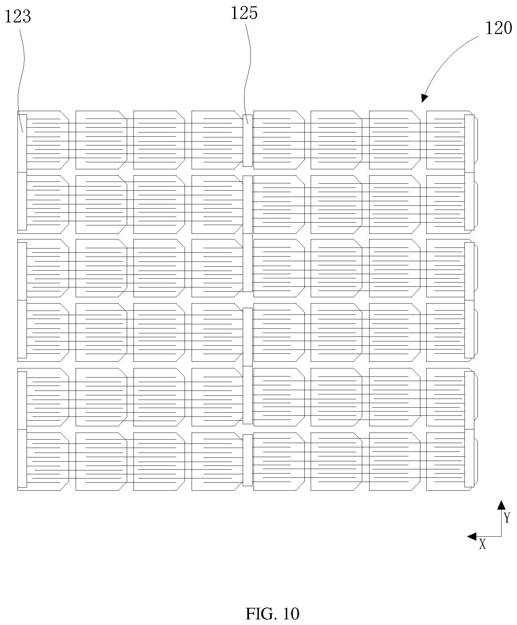

Referring to FIG. 10, the plurality of cell strings 120 are arranged at intervals along the second direction, and each cell sheet 121 of adjacent cell strings 120 are aligned in the second direction in one-to-one correspondence. It should be understood that the interval between every two adjacent cell strings 120 can be set as required to meet different requirements.

Step S9, two first bus ribbons of adjacent two cell strings are soldered, or second bus ribbons of adjacent two cell strings are soldered.

Referring to FIG. 10, at least a part of adjacent two cell strings 120 are electrically connected to each other through the first bus ribbons 123, and at least a part of adjacent two cell strings 120 are electrically connected to each other through the second bus ribbons 125, thereby achieving electrical connection of the plurality of cell strings 120. In one embodiment, two first bus ribbons 123 and two second bus ribbons 125 are interconnected to each other by a tiling ribbon technology, respectively.

In one embodiment, in any cell string 120 located between two cell strings 120, two first bus ribbons 123 of the cell string 120 are connected to the first bus ribbons 123 of another cell string 120 located on one side thereof, and the second bus ribbon 125 of the cell string 120 is connected to another second bus ribbon 125 of another cell string 120 located on another side thereof. That is, along the second direction from one side to another side of the plurality of cell strings 120, the first bus ribbons 123 of the first cell string 120 and the second cell string 120 are interconnected, the second bus ribbons 125 of the second cell string 120 and the third cell string 120 are interconnected, and the first bus ribbons 123 of the third cell string 120 and the fourth cell string 120 are interconnected.

A tiling ribbon refers to an overlapping soldering of ends of two bus ribbons. In one embodiment, the two interconnected first bus ribbons 123 respectively protrude from the plurality of cell sheets 121 along the second direction to reserve soldering positions. A length of each first bus ribbon 123 protruding from the cell sheet 121 is in a range of 4 mm to 5 mm, and an overlapping length of the two first bus ribbons 123 is in range of 1 mm to 2.5 mm, for example 1.5 mm. The two interconnected second bus ribbons 125 respectively protrude from the plurality of cell sheets 121 to reserve soldering positions. A length of each second bus ribbon 125 protruding from the cell sheet 121 is in a range of 4 mm to 5 mm, and an overlapping length of the two second bus ribbons 125 is in range of 1 mm to 2.5 mm, for example 1.5 mm, so as to achieve a better connection effect.

In some embodiments, in two cell strings 120 located at opposite ends of the busbar-free back-contact photovoltaic module 100 along the second direction, one end of the two first bus ribbons 123 protrudes from the cell sheets 121 to connect the first bus ribbons 123 of adjacent cell strings 120. In each of the remaining cell strings 120, one end of the two first bus ribbons 123 protrudes from one side of the cell sheets 121 in the second direction, and one end of the second bus ribbon 125 protrudes from another side of the cell sheets 121 in the second direction, and the placement angles of adjacent two cell strings 120 differ by 180°, such that the first bus ribbons 123 or the second bus ribbons 125 of adjacent two cell strings 120 are connected to each other.

In some embodiments, the method for preparing the busbar-free back-contact photovoltaic module 100 further includes step S10, a cover plate and an encapsulation layer are provided, and the cover plate, the encapsulation layer, and the cell string are treated by a lamination process to form the busbar-free back-contact photovoltaic module.

In one embodiment, the cover plate, the encapsulation layer, the cell string 120, the encapsulation layer, and the cover plate can be stacked sequentially, and then the aforementioned stacked structure can be treated by a lamination process. During the lamination process, the lamination temperature and lamination pressure can be used to achieve electrical connection between the solder ribbons and the cell sheets 121 and form a busbar-free back-contact photovoltaic module 100.

The cover plate can be a glass cover plate, a plastic cover plate or the like with light-transmitting function. The encapsulation layer can be an organic encapsulation film such as ethylene-vinyl acetate copolymer (EVA) film, polyethylene octene co-elastomer (POE) film, or polyethylene terephthalate (PET) film.

The aforementioned method for preparing the busbar-free back-contact photovoltaic module 100 can be applied to the production of busbar-free back-contact photovoltaic modules 100. Since the first bus ribbon 123 and the second bus ribbon 125 are both arranged on the backlight side of the cell sheet 121, there is no need to arrange a bus ribbon between the cell sheet 121 and the edge of the cover plate, thereby effectively reducing the gap in the busbar-free back-contact photovoltaic module 100, which can in turn effectively increase the overall size of the busbar-free back-contact photovoltaic module 100 and improve the power of the busbar-free back-contact photovoltaic module 100.

In addition, since the first bus ribbon 123 and the second solder ribbons 124 are independently formed into a first assembly, and the second bus ribbon 125 and the third solder ribbons 126 are independently formed into a second assembly, the preparation process of the busbar-free back-contact photovoltaic module 100 is simplified, and the problem of grid line breakage caused by secondary soldering is effectively prevented.

Specifically, in one embodiment, the method for preparing the busbar-free back-contact photovoltaic module 100 includes the following steps.

First, a plurality of cell sheets 121 are arranged at intervals along a first direction.

Then, a plurality of first solder ribbons 122 are laid on all the cell sheets 121, and each first solder ribbon 122 extends along the first direction to connect adjacent two cell sheets 121. Except for two cell sheets 121 located in the middle portion of the cell string 120 in the first direction that are not connected to each other through the first solder ribbon 122, the remaining adjacent two cell sheets 121 are connected through the plurality of first solder ribbons 122, and all the first solder ribbons 122 connecting the same two cell sheets 121 are arranged at intervals along the second direction.

Then, a glue is applied on the cell sheets 121 and the first solder ribbons 122 to form a plurality of glue spots 127. Two ends of each first solder ribbon 122 are connected to the cell sheets 121 through at least two glue spots 127 spaced apart in a length direction thereof, and the plurality of glue spots 127 are adjacent to two edges of the cell sheet 121 in the first direction.

Then, a first bus ribbon 123 and a plurality of second solder ribbons 124 are connected to form a first assembly. The plurality of second solder ribbons 124 are arranged at intervals along a length direction of the first bus ribbon 123. One end of each second solder ribbon 124 is connected to the first bus ribbon 123 by soldering, and another end of each second solder ribbon 124 extends along a width direction of the first bus ribbon 123. A second bus ribbon 125 and a plurality of third solder ribbons 126 are connected to form a second assembly. The plurality of third solder ribbons 126 are arranged at intervals along a length direction of the second bus ribbon 125. A middle portion of each third solder ribbon 126 is connected to the second bus ribbon 125 by soldering, and two ends of each third solder ribbon 126 extend towards two sides of the second bus ribbon 125 along a width direction of the second bus ribbon 125, respectively.

Then, the first bus ribbon 123 is laid on outer edges of the cell sheets 121 located at two ends of the cell string 120 along the first direction, and the plurality of second solder ribbons 124 are laid on the cell sheets 121 located at two ends of the cell string 120 along the first direction, respectively. The first solder ribbons 122 and the second solder ribbons 124 are arranged alternately. The second bus ribbon 125 is laid between adjacent two cell sheets 121 located in a middle portion of the cell string 120, and the plurality of third solder ribbons 126 are laid on two cell sheets 121 located on both sides of the second bus ribbon 125 along the first direction. The first solder ribbons 122 and the third solder ribbons 126 are arranged alternately.

Then, a glue is applied on the cell sheets 121 and the second solder ribbons 124 to form a plurality of glue spots 127. Each second solder ribbon 124 is provided with at least two glue spots 127, and all glue spots 127 on the same second solder ribbon 124 are arranged at opposite ends of the second solder ribbon 124 in the length direction of the second solder ribbon 124. A glue is applied on the cell sheets 121 and the third solder ribbons 126 to form a plurality of glue spots 127. At least two glue spots 127 are respectively provided at two ends of each third solder ribbon 126 in the length direction, such that each third solder ribbon 126 is connected to one cell sheet 121 through the at least two glue spots 127, and the two glue spots 127 located on the same cell sheet 121 are adjacent to two edges of the cell sheet 121 in the first direction, respectively.

Then, a plurality of cell strings 120 provided with the first assembly and the second assembly are arranged at intervals along the second direction perpendicular to the first direction. Two first bus ribbons 123 of adjacent two cell strings 120, or two second bus ribbons 125 of adjacent two cell strings 120 are soldered. In any cell string 120 located between two cell strings 120, two first bus ribbons 123 of the cell string 120 are connected to the first bus ribbons 123 of another cell string 120 located on one side thereof, and the second bus ribbon 125 of the cell string 120 is connected to the second bus ribbon 125 of another cell string 120 located on another side thereof.

As shown in FIG. 1, an embodiment of the present invention further provides a busbar-free back-contact photovoltaic module 100, which is prepared by the aforementioned method.

The busbar-free back-contact photovoltaic module 100 is substantially shaped as a rectangular. A length direction of the busbar-free back-contact photovoltaic module 100 is a first direction (i.e., the X direction in FIG. 1), and a width direction of the busbar-free back-contact photovoltaic module 100 is a second direction (i.e., the Y direction in FIG. 1), and the first direction and the second direction are perpendicular to each other.

The busbar-free back-contact photovoltaic module 100 includes a cover plate, an encapsulation layer, and a cell string layer. The cover plate, the encapsulation layer, the cell string layer, the encapsulation layer, and the cover plate are stacked along a third direction. The cell string layer includes a plurality of cell strings 120 arranged along the second direction. Each cell string 120 includes a plurality of cell sheets 121, a plurality of first solder ribbons 122, a first bus ribbon 123, a plurality of second solder ribbons 124, a second bus ribbon 125, and a plurality of third solder ribbons 126.

In one embodiment, in each cell string 120, all cell sheets 121 are arranged at intervals along the first direction. The first solder ribbons 122 are in a ribbon-shaped structure with certain flexibility, and a material of the first solder ribbons 122 includes but is not limited to tin-lead alloy and lead-free alloy (such as tin-silver-copper alloy). The plurality of first solder ribbons 122 are laid on at least a part the cell sheets 121, and each first solder ribbon 122 is connected to adjacent two cell sheets 121, thereby forming a good electrical connection between the cell sheets 121, which then collects and conducts the current generated by each cell sheet 121.

In one embodiment, each first solder ribbon 122 extends along the first direction, and both ends of each first solder ribbon 122 in the first direction are respectively laid on adjacent two cell sheets 121 to connect the adjacent two cell sheets 121. All the first solder ribbons 122 connecting the same two cell sheets 121 are arranged at intervals in the second direction, and the interval between every two adjacent first solder ribbons 122 in the second direction can be arranged as required. In some embodiments, except for two cell sheets 121 located in a middle portion in the first direction that are not connected to each other through the first solder ribbon 122, the adjacent two cell sheets 121 are connected through the plurality of first solder ribbons 122.

The first bus ribbons 123 are arranged at outer edges of two cell sheets 121 located at two ends of the cell string 120 along the first direction, and the first bus ribbon 123 extends along the second direction. The plurality of second solder ribbons 124 are laid on the cell sheets 121 located at two ends of the cell string 120 along the first direction, and the plurality of second solder ribbons 124 are arranged at intervals along the second direction. One end of each second solder ribbon 124 is connected to the first bus ribbon 123, and another end of each second solder ribbon 124 extends along the first direction away from the first bus ribbon 123. The first solder ribbons 122 and the second solder ribbons 124 on the cell sheets 121 are arranged alternately in the second direction.

The second bus ribbon 125 is laid between adjacent two cell sheets 121 located in a middle portion of the cell string 120, and the second bus ribbon 125 extends along the second direction. The plurality of third solder ribbons 126 are arranged at intervals along the second direction. A middle portion of each third solder ribbon 126 is connected to the second bus ribbon 125, and two ends of each third solder ribbon 126 extend along the first direction away from the second bus ribbon 125 and are located on two cell sheets 121, respectively. The third solder ribbons 126 and the first solder ribbons 122 on the two cell sheets 121 are arranged alternately in the second direction.

In some embodiments, in any cell string 120 located between two cell strings 120, one first bus ribbon 123 is connected to another first bus ribbon 123 of another cell string 120 located on one side thereof by a tiling ribbon technology, and one second bus ribbon 125 is connected to another second bus ribbon 125 of another cell string 120 located on another side thereof by a tiling ribbon technology.

In the aforementioned busbar-free back-contact photovoltaic module 100, since the first bus ribbon 123 and the second bus ribbon 125 are both arranged on the backlight side of the cell sheet 121, there is no need to arrange a bus ribbon between the cell sheet 121 and the edge of the cover plate, thereby effectively reducing the gap of the busbar-free back-contact photovoltaic module 100, which can in turn effectively increase the overall size of the busbar-free back-contact photovoltaic module 100 and improve the power of the busbar-free back-contact photovoltaic module 100.

## Claims

1. A method for preparing a busbar-free back-contact photovoltaic module (100), comprising:
arranging a plurality of cell sheets (121) at intervals along a first direction;
laying a plurality of first solder ribbons (122) on at least a part of the plurality of cell sheets (121) to form a cell string (120), wherein each of the plurality of first solder ribbons (122) is connected to adjacent two cell sheets (121);
connecting a first bus ribbon (123) and a plurality of second solder ribbons (124) to form a first assembly, and connecting a second bus ribbon (125) and a plurality of third solder ribbons (126) to form a second assembly; and
laying the first assembly and the second assembly on the cell string (120), respectively;
wherein laying the first assembly and the second assembly on the cell string (120), respectively comprises:
laying the first bus ribbon (123) on outer edges of the cell sheets (121) located at two ends of the cell string (120) along the first direction, respectively, and laying the plurality of second solder ribbons (124) on the cell sheets (121) located at two ends of the cell string (120) along the first direction; and
laying the second bus ribbon (125) between adjacent two cell sheets (121), and laying the plurality of third solder ribbons (126) on two cell sheets (121) located on both sides of the second bus ribbon (125) along the first direction.

2. The method according to claim 1, wherein the plurality of second solder ribbons (124) and the plurality of first solder ribbons (122) are arranged alternately in a second direction perpendicular to the first direction; and/or
the plurality of third solder ribbons (126) and the plurality of first solder ribbons (122) are arranged alternately in a second direction perpendicular to the first direction.

3. The method according to claim 1, wherein after laying the plurality of first solder ribbons (122) on at least a part of the plurality of cell sheets (121) to form the cell string (120), the method further comprises:
applying a glue on the plurality of cell sheets (121) and the plurality of first solder ribbons (122) to form a plurality of glue spots (127), wherein the plurality of cell sheets (121) and the plurality of first solder ribbons (122) are connected through the plurality of glue spots (127);
optionally, two ends of at least a part of the plurality of first solder ribbons (122) are connected to the plurality of cell sheets (121) through at least two glue spots (127) spaced apart in a length direction thereof.

4. The method according to any one of claims 1 to 3, further comprising applying a glue on the plurality of cell sheets (121) and the plurality of second solder ribbons (124) to form a plurality of glue spots (127), wherein the plurality of cell sheets (121) and the plurality of second solder ribbons (124) are connected through the plurality of glue spots (127);
optionally, at least a part of the plurality of second solder ribbons (124) is provided with at least two glue spots (127), and all the glue spots (127) on a same second solder ribbon (124) are respectively provided at opposite ends of the second solder ribbon (124) in a length direction thereof.

5. The method according to any one of claims 1 to 3, further comprising applying a glue on the plurality of cell sheets (121) and the plurality of third solder ribbon (126) to form a plurality of glue spots (127), wherein the plurality of cell sheets (121) and the plurality of third solder ribbons (126) are connected through the plurality of glue spots (127);
optionally, at least a part of the plurality of third solder ribbons (126) is provided with at least two glue spots (127), and all the glue spots (127) on a same third solder ribbon (126) are respectively provided at opposite ends of the third solder ribbon (126) in a length direction thereof.

6. The method according to claim 1, further comprising:
arranging a plurality of cell strings (120) at intervals along a second direction perpendicular to the first direction; and
soldering the plurality of first bus ribbons (123) or the plurality of second bus ribbons (125) of adjacent two cell strings (120).

7. The method according to claim 1, wherein the plurality of first solder ribbons (122) connecting a same two cell sheets (121) are arranged at intervals in a second direction perpendicular to the first direction.

8. The method according to claim 3, wherein the at least two glue spots (127) on two ends of the plurality of first solder ribbon (122) in the length direction thereof are adjacent to two edges of the plurality of cell sheets (121) in the first direction, respectively.

9. The method according to claim 1, wherein in the first assembly, one end of the plurality of second solder ribbons (124) is connected to the first bus ribbon (123), and another end thereof extends along a width direction of the first bus ribbon (123) towards one side of the first bus ribbon (123).

10. The method according to claim 1, wherein in the second assembly, a middle portion of the plurality of third solder ribbons (126) is connected to the second bus ribbon (125), and two ends of the plurality of third solder ribbons (126) extend along a width direction of the second bus ribbon (125) towards two side of the second bus ribbon (125), respectively.

11. The method according to claim 6, wherein two first bus ribbons (123) or two second bus ribbons (125) are interconnected to each other by a tiling ribbon technology.

12. The method according to claim 11, wherein the two interconnected first bus ribbons (123) or second bus ribbons (125) protrude from the plurality of cell sheets (121) along the second direction;
optionally, a length of each first bus ribbon (123) or second bus ribbon (125) protruding from the cell sheet (121) is in a range of 4 mm to 5 mm, and an overlapping length of the two first bus ribbons (123) or the two second bus ribbons (125) is in range of 1 mm to 2.5 mm.

13. The method according to claim 1, further comprising:
providing a cover plate and an encapsulation layer, and
treating the cover plate, the encapsulation layer, and the cell string (120) by a lamination process to form the busbar-free back-contact photovoltaic module (100).

14. A busbar-free back-contact photovoltaic module (100), comprising a plurality of cell strings (120) arranged at intervals, wherein each of the plurality of cell strings (120) comprises:
a plurality of cell sheets (121) arranged at intervals along a first direction;
a plurality of first solder ribbons (122) laid on at least a part of the plurality of cell sheets (121), wherein each of the plurality of first solder ribbons (122) is connected to adjacent two cell sheets (121);
a first bus ribbon (123) provided at outer edges of the cell sheets (121) located at two ends of the cell string (120) along the first direction;
a plurality of second solder ribbons (124) that are connected to the first bus ribbon (123) and provided on the cell sheets (121) located at two ends of the cell string (120) along the first direction;
a second bus ribbon (125) provided between adjacent two cell sheets (121); and
a plurality of third solder ribbons (126) that are connected to the second bus ribbon (125) and provided on two cell sheets (121) located on both sides of the second bus ribbon (125) along the first direction.

15. The busbar-free back-contact photovoltaic module (100) according to claim 14, wherein in any cell string (120) located between two cell strings (120), one first bus ribbon (123) is connected to another first bus ribbon (123) of another cell string (120) located on one side thereof, and one second bus ribbon (125) is connected to another second bus ribbon (125) of another cell string (120) located on another side thereof.
